(19) Europäisches Patentamt / European Patent Office / Office européen des brevets

(11) **EP 3 647 798 B1**

(12) **FASCICULE DE BREVET EUROPEEN**

(45) Date de publication et mention
de la délivrance du brevet:
**27.01.2021 Bulletin 2021/04**

(51) Int Cl.:
***G01R 31/12*** *(2020.01)*

(21) Numéro de dépôt: **19206314.7**

(22) Date de dépôt: **30.10.2019**

(54) **PROCÉDÉ ET DISPOSITIF DE DÉTECTION D'UN ARC ÉLECTRIQUE DANS UN SYSTÈME ÉLECTRIQUE**

VERFAHREN UND VORRICHTUNG ZUR DETEKTION EINES LICHTBOGENS IN EINEM ELEKTRISCHEN SYSTEM

METHOD AND DEVICE FOR DETECTING AN ELECTRIC ARC IN AN ELECTRICAL SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.11.2018 FR 1871353**

(43) Date de publication de la demande:
**06.05.2020 Bulletin 2020/19**

(73) Titulaires:
- **Commissariat à l'Energie Atomique et aux Energies Alternatives**
  **75015 Paris (FR)**
- **Université Grenoble Alpes**
  **38400 Saint-Martin-d'Hères (FR)**
- **Institut Polytechnique de Grenoble**
  **38000 Grenoble (FR)**
- **CENTRE NATIONAL DE LA RECHERCHE SCIENTIFIQUE**
  **75794 Paris Cedex 16 (FR)**

(72) Inventeurs:
- **DJIGO, Ibrahima**
  **38054 GRENOBLE CEDEX 09 (FR)**
- **HEIRIES, Vincent**
  **38054 GRENOBLE CEDEX 09 (FR)**
- **MICHEL, Olivier**
  **38000 GRENOBLE (FR)**

(74) Mandataire: **Cabinet Beaumont**
**4, Place Robert Schuman**
**B.P. 1529**
**38025 Grenoble Cedex 1 (FR)**

(56) Documents cités:
**EP-A1- 3 018 781 US-A1- 2018 204 132**

- XIE QING ET AL: "Application of signal sparse decomposition in the detection of partial discharge by ultrasonic array method", IEEE TRANSACTIONS ON DIELECTRICS AND ELECTRICAL INSULATION, IEEE SERVICE CENTER, PISCATAWAY, NJ, US, vol. 22, no. 4, 1 août 2015 (2015-08-01), pages 2031-2040, XP011666193, ISSN: 1070-9878, DOI: 10.1109/TDEI.2015.004955 [extrait le 2015-08-04]
- XUE JIANG ET AL: "A Fast Algorithm for Sparse Channel Estimation via Orthogonal Matching Pursuit", VEHICULAR TECHNOLOGY CONFERENCE (VTC SPRING), 2011 IEEE 73RD, IEEE, 15 mai 2011 (2011-05-15), pages 1-5, XP031896644, DOI: 10.1109/VETECS.2011.5956242 ISBN: 978-1-4244-8332-7
- SCHNIER TOBIAS ET AL: "SparkDict: A fast dictionary learning algorithm", 2017 25TH EUROPEAN SIGNAL PROCESSING CONFERENCE (EUSIPCO), EURASIP, 28 août 2017 (2017-08-28), pages 1564-1568, XP033236248, DOI: 10.23919/EUSIPCO.2017.8081472
- SILVA FERNANDO THOME DE AZEVEDO ET AL: "Partial discharge signal processing using overcomplete dictionaries and sparse representations", 2017 IEEE ELECTRICAL INSULATION CONFERENCE (EIC), IEEE, 11 juin 2017 (2017-06-11), pages 388-391, XP033138765, DOI: 10.1109/EIC.2017.8004618 ISBN: 978-1-5090-3965-4 [extrait le 2017-08-08]

- **SILVA FERNANDO THOME DE A ET AL: "A systematic method to compose over complete dictionaries for the processing of partial discharge signals", 2017 2ND INTERNATIONAL SYMPOSIUM ON INSTRUMENTATION SYSTEMS, CIRCUITS AND TRANSDUCERS (INSCIT), IEEE, 28 août 2017 (2017-08-28), pages 1-6, XP033251819, DOI: 10.1109/INSCIT.2017.8103524**
- **AHARON M ET AL: "K-SVD: An Algorithm for Designing Overcomplete Dictionaries for Sparse Representation", IEEE TRANSACTIONS ON SIGNAL PROCESSING, IEEE SERVICE CENTER, NEW YORK, NY, US, vol. 54, no. 11, 1 novembre 2006 (2006-11-01), pages 4311-4322, XP007916325, ISSN: 1053-587X [extrait le 2006-10-16]**
- **PATI Y C ET AL: "Orthogonal matching pursuit: recursive function approximation with applications to wavelet decomposition", SIGNALS, SYSTEMS AND COMPUTERS, 1993. 1993 CONFERENCE RECORD OF THE TWENTY-SEVENTH ASILOMAR CONFERENCE ON PACIFIC GROVE, CA, USA 1-3 NOV. 1993, LOS ALAMITOS, CA, USA,IEEE COMPUT. SOC, 1 novembre 1993 (1993-11-01), pages 40-44, XP010096293, DOI: 10.1109/ACSSC.1993.342465 ISBN: 978-0-8186-4120-6**

**Description**

Domaine technique

La présente description concerne un procédé et un dispositif pour détecter la formation d'un arc électrique dans un système électrique à partir de sa signature acoustique.

Technique antérieure

Dans de nombreux systèmes électriques, notamment des systèmes haute tension tels que des armoires électriques, des transformateurs, des batteries électriques, des réseaux de distribution électrique, etc., des arcs électriques peuvent se former, par exemple par suite d'une surtension ou d'une défaillance telle que la rupture d'un câble ou l'usure d'un isolant. S'il est entretenu, un arc électrique peut provoquer de graves dommages et notamment entraîner un départ de feu. Les arcs électriques sont tout particulièrement dangereux dans les systèmes électriques à alimentation continue, dans la mesure où l'on ne peut pas compter sur un passage à zéro "naturel" de la tension d'alimentation pour provoquer l'extinction de l'arc. La détection précoce de la formation d'un arc électrique est un enjeu majeur pour la sécurité de nombreux systèmes électriques.

Diverses solutions ont été proposées pour détecter la formation d'un arc électrique dans un système électrique. On a notamment proposé des méthodes de détection basées sur des mesures de courant et de tension dans le système, des méthodes de détection basées sur des mesures de signaux optiques, des méthodes de détection basées sur des mesures de signaux électromagnétiques, et des méthodes de détection basées sur des mesures de signaux acoustiques.

On s'intéresse ici plus particulièrement aux méthodes de détection basées sur des mesures de signaux acoustiques. L'article intitulé "Application of signal sparse decomposition in the detection of partial discharge by ultrasonic array method" de Q. Xie, Y. Wang, T. Li, X. Bian, H. Zhang et Y. Xu (IEEE Transactions on Dielectrics and Electrical Insulation, vol. 22, no. 4, pp. 2031-2040, Aout 2015) et l'article intitulé "A Fast Algorithm for Sparse Channel Estimation via Orthogonal Matching Pursuit" de X. Jiang, W. Zeng and E. Cheng (IEEE 73rd Vehicular Technology Conference (VTC Spring), Yokohama, 2011, pp. 1-5) décrivent des exemples de procédés de détection basés sur des mesures de signaux acoustiques.

Résumé de l'invention

Ainsi, un mode de réalisation prévoit un procédé de détection d'un arc électrique dans un système électrique, selon la revendication 1.

Selon un mode de réalisation, le seuil est calculé en fonction de valeurs spécifiées de probabilité de fausse alarme et de probabilité de non détection.

Selon un mode de réalisation, le seuil est égal à 1.

Selon un mode de réalisation, à l'étape b), la première valeur est déterminée par un algorithme itératif de poursuite adaptative comprenant les étapes successives suivantes :

e1) définir un vecteur résidu ERR0 et lui affecter la valeur du signal ;
e2) rechercher dans la première matrice dictionnaire le vecteur colonne D0<j> le plus corrélé avec le vecteur résidu ERR0 ;
e3) soustraire au vecteur résidu ERR0 la contribution au vecteur résidu ERR0 du vecteur colonne D0<j> déterminé à l'étape précédente ;
e4) répéter les étapes e2) et e3) un nombre T0 prédéterminé de fois ; et
e5) affecter à la première valeur une valeur représentative de la norme du vecteur résidu ERR0.

Selon un mode de réalisation, à l'étape c), la deuxième valeur est déterminée par un algorithme itératif de poursuite adaptative comprenant les étapes successives suivantes :

e1') définir un vecteur résidu ERR1 et lui affecter la valeur du signal ;
e2') rechercher dans la deuxième matrice dictionnaire le vecteur colonne D1<j> le plus corrélé avec le vecteur résidu ERR1 ;
e3') soustraire au vecteur résidu ERR1 la contribution au vecteur résidu ERR1 du vecteur colonne D1<j> déterminé à l'étape précédente ;
e4') répéter les étapes e2') et e3') un nombre T1 prédéterminé de fois ; et
e5') affecter à la deuxième valeur une valeur représentative de la norme du vecteur résidu ERR1.

Selon un mode de réalisation, le procédé comprend en outre une étape de mise en sécurité du système électrique lorsqu'il est déterminé à l'étape d) qu'un arc électrique est survenu dans le système électrique.

Selon un mode de réalisation, l'étape de mise en sécurité comprend le déclenchement d'une alarme.

Selon un mode de réalisation, l'étape de mise en sécurité comprend l'interruption d'un courant électrique d'alimentation du système électrique.

Un autre mode de réalisation prévoit un dispositif de détection d'un arc électrique dans un système électrique, comprenant un capteur détectant des ondes acoustiques dans le système, et un dispositif électronique de traitement adapté à mettre en oeuvre un procédé tel que défini ci-dessus.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre un système électrique muni d'un dispositif de détection d'un arc électrique selon un exemple d'un mode de réalisation ;

la figure 2 est un organigramme illustrant des étapes d'un procédé de détection d'un arc électrique selon un exemple d'un mode de réalisation ; et

la figure 3 illustre un dispositif adapté à la mise en oeuvre d'un procédé de détection d'un arc électrique selon un exemple d'un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les systèmes électriques dans lesquels on cherche à détecter des arcs électriques n'ont pas été détaillés, les solutions de détection décrites étant compatibles avec tous les systèmes électriques dans lesquels peuvent se produire des arcs électriques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près, et encore plus préférentiellement à 1 % près.

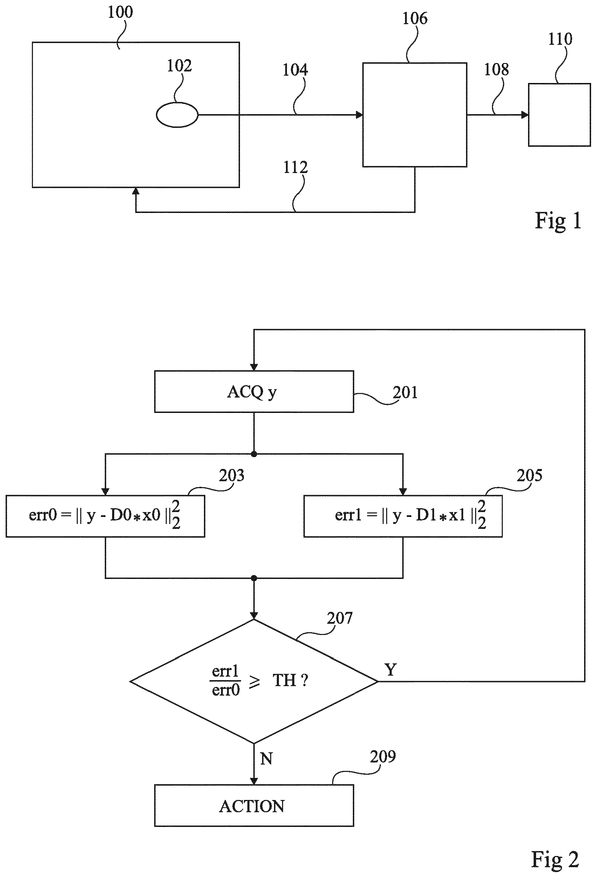

La figure 1 représente un système électrique 100 à surveiller, par exemple une armoire électrique, un réseau de distribution d'électricité dans un avion, une batterie électrique, ou tout autre système électrique dans lequel on souhaite pouvoir détecter l'apparition éventuelle d'un arc électrique.

Le système électrique 100 est équipé d'un dispositif de détection d'un arc électrique comportant un capteur acoustique 102, par exemple un capteur à ultrasons, adapté à détecter des ondes acoustiques dans le système électrique 100. La formation d'un arc électrique s'accompagne en effet de l'émission d'ondes acoustiques caractéristiques dont la détection peut permettre d'identifier la présence de l'arc. Le capteur 102 peut être disposé sur une paroi d'un boîtier du système électrique 100, ou en contact physique avec un conducteur électrique que l'on souhaite surveiller tout particulièrement dans le système 100. Bien qu'un seul capteur 102 soit illustré en figure 1, dans des variantes de réalisation, plusieurs capteurs 102 peuvent être prévus pour surveiller différentes parties du système 100.

Le capteur 102 fournit un signal de sortie 104 à un dispositif électronique de traitement 106 du dispositif de détection d'un arc électrique. A titre d'exemple, le signal de sortie 104 du capteur 102 est un signal numérique, et le dispositif de traitement 106 est un circuit de traitement numérique comprenant par exemple un microprocesseur. Le signal de sortie 104 est un signal dans le domaine temporel, représentant l'évolution en fonction du temps de l'amplitude des ondes acoustiques captées par le capteur 102. Le dispositif de traitement 106 est adapté à analyser le signal fourni par le capteur 102 pour détecter la présence éventuelle d'un arc électrique dans le système 100.

Le signal acoustique 104 est par exemple généré par un unique capteur acoustique.

Le dispositif de traitement 106 fournit par exemple un signal de sortie 108 à un module de sortie 110 du dispositif de détection d'un arc électrique, qui peut être une alarme, un afficheur, ou tout autre élément d'interface permettant d'informer un utilisateur de la présence d'un arc dans le système 100.

Le dispositif de traitement 106 peut fournir, en plus ou à la place du signal de sortie 108, un signal de sortie 112 renvoyé vers le système 100, qui peut par exemple commander la mise en sécurité du système 100 lorsqu'un arc électrique est détecté, par exemple par interruption du courant d'alimentation dans tout ou partie du système 100. A titre d'exemple, dans le cas où le capteur 102 est disposé en contact avec un conducteur électrique du système 100, le courant électrique circulant dans ce conducteur peut être interrompu lorsqu'un arc est détecté.

La figure 2 est un organigramme illustrant des étapes d'un exemple d'un procédé de détection d'un arc électrique selon un mode de réalisation. Ce procédé peut être mis en oeuvre par le dispositif de traitement 106 du dispositif de détection d'arc électrique de la figure 1 pour réaliser une surveillance continue du système 100 et détecter au plus vite la formation d'un arc électrique.

Le procédé de la figure 2 comprend une étape 201 d'acquisition d'un signal y correspondant à une suite de n échantillons consécutifs y[i] du signal de sortie 104 du capteur 102, où n est un entier supérieur ou égal à 2, et i est un entier allant de 1 à n. A titre d'exemple, le nombre d'échantillons n du signal y est compris entre 1000 et 10000, par exemple de l'ordre de 6000. La fréquence d'acquisition des échantillons est par exemple comprise entre 200 kHz et 10 Mhz, par exemple de l'ordre de 1 MHz (soit une durée d'acquisition d'environ 6 ms pour un signal y d'environ 6000 échantillons).

Le procédé comprend en outre, après l'étape 201 :

- une étape 203 de détermination, au moyen du dispositif de traitement 106, d'une projection x0 du signal y dans un espace de représentation défini par une matrice dictionnaire D0, et d'une valeur de résidu err0 représentative de l'erreur entre le signal y et la projection x0 ; et
- une étape 205 de détermination, au moyen du dispositif de traitement 106, d'une projection x1 du signal y dans un espace de représentation défini par une matrice dictionnaire D1, et d'une valeur de résidu err1 représentative de l'erreur entre le signal y et la projection x1.

La matrice D1 est choisie de façon que l'erreur de projection err1 du signal y sur la matrice D1 soit relativement faible lorsque le signal y est un signal acoustique caractéristique d'un arc électrique, et relativement forte lorsque le signal y est un signal acoustique caractéristique de tout autre phénomène susceptible de se produire pendant le fonctionnement normal du système électrique sous-surveillance et générant des ondes acoustiques dans le système. Par la suite, par souci de simplification, on appellera ci-après "choc" tout phénomène autre qu'un arc électrique susceptible de se produire pendant le fonctionnement normal du système et générant des ondes acoustiques pouvant être mesurées par le capteur 102.

La matrice D0 est quant à elle choisie de façon que l'erreur de projection err0 du signal y sur la matrice D0 soit relativement faible lorsque le signal y est un signal acoustique caractéristique d'un choc, et relativement forte lorsque le signal y est un signal acoustique caractéristique d'un arc électrique.

Autrement dit, les matrices D1 et D0 sont déterminées, lors d'une phase d'apprentissage (comme cela sera décrit plus en détail ci-après), de façon que la matrice D1 soit plus caractéristique des arcs électriques que des chocs, et de façon que la matrice D0 soit plus caractéristique des chocs que des arcs électriques.

Les matrices D0 et D1 sont des matrices de n lignes par respectivement K0 et K1 colonnes, avec K0 et K1 entiers supérieurs ou égaux à 2 et, de préférence, strictement inférieurs à n. Ainsi, les projections x0 et x1 d'un signal acoustique y de dimension n sur les matrices D0 et D1 sont respectivement un vecteur de dimension K0 et un vecteur de dimension K1.

A titre d'exemple, les valeurs d'erreur de projection err0 et err2 sont définies comme suit :

[Math 1]

$$\mathrm{err0} = \lVert y - D0 * x0 \rVert_2^2$$

[Math 2]

$$\mathrm{err1} = \lVert y - D1 * x1 \rVert_2^2$$

Lors des étapes 203 et 205, les projections x0 et x1 peuvent être déterminées par toute méthode connue de détermination d'une projection d'un signal y sur une matrice dictionnaire. De préférence, on utilise un algorithme de poursuite adaptative ("matching pursuit" en anglais), par exemple un algorithme de poursuite adaptative orthogonale ("orthogonal matching pursuit" en anglais), pour déterminer la projection x0 et l'erreur de projection err0 d'une part, et la projection x1 et l'erreur de projection err1 d'autre part. De tels algorithmes sont par exemple décrits dans l'article intitulé "Adaptive time-frequency decompositions with matching pursuits" de G. Davis et al. (1994, Optical Engineering. 33: 2183.), et dans l'article intitulé "Orthogonal Matching Pursuit: recursive function approximation with application to wavelet Decomposition" de Y. Pati et al. (1993, Asilomar Conf. on Signals, Systems and Comput.).

A titre d'exemple, l'erreur de projection err0 du signal y sur la matrice D0 est déterminée par un algorithme itératif de poursuite adaptative comprenant les étapes successives suivantes :

> e1) définir un vecteur résidu ERRO de dimension n et lui affecter la valeur y (ERRO=y) ;
> e2) rechercher dans la matrice dictionnaire D0 le vecteur colonne de dimension n D0<j> le plus corrélé avec le vecteur résidu ERRO, c'est-à-dire celui dont le produit scalaire avec le vecteur résidu ERRO est le plus grand en valeur absolue (avec j entier compris dans la plage allant de 1 à KO) ; et
> e3) soustraire au vecteur résidu ERRO la contribution au vecteur résidu ERRO du vecteur colonne D0<j> déterminé à l'étape précédente, et réaffecter au vecteur résidu ERRO le résultat de la soustraction (ERRO = ERRO - <ERR0 ; D0<j>>*D0<j>, où <ERR0 ; D0O<j>> désigne le produit scalaire des vecteurs ERRO et D0<j>).

Les étapes e2 et e3 sont répétées T0 fois, où T0 est un entier prédéterminé supérieur ou égal à 2.

A l'issue des T0 itérations, l'erreur de projection err0 du signal y sur la matrice D0 peut être définie comme suit :

[Math 3]

$$err0 = \|ERR0\|_2^2$$

De façon similaire, l'erreur de projection err1 du signal y sur la matrice D1 peut être déterminée par un algorithme itératif de poursuite adaptative comprenant les étapes successives suivantes :

> e1') définir un vecteur résidu ERR1 de dimension n et lui affecter la valeur y (ERR1=y) ;
> e2') rechercher dans la matrice dictionnaire D1 le vecteur colonne de dimension n D1<j'> le plus corrélé avec le vecteur résidu ERR1, c'est-à-dire celui dont le produit scalaire avec le vecteur résidu ERR1 est le plus grand en valeur absolue (avec j' entier compris dans la plage allant de 1 à K1) ; et
> e3') soustraire au vecteur résidu ERR1 la contribution au vecteur résidu ERR1 du vecteur colonne D1<j'> déterminé à l'étape précédente, et réaffecter au vecteur résidu ERR1 le résultat de la soustraction (ERR1 = ERR1 - <ERR1 ; D1<j'>>*D1<j'>, où <ERR1 ; D1<j'>> désigne le produit scalaire des vecteurs ERR1 et D1<j'>).

Les étapes e2' et e3' sont répétées T1 fois, où T1 est un entier prédéterminé supérieur ou égal à 2.

A l'issue des T1 itérations, l'erreur de projection err1 du signal y sur la matrice D1 peut être définie comme suit :

[Math 4]

$$err1 = \|ERR1\|_2^2$$

Les valeurs T0 et T1 peuvent être déterminées lors d'une phase de paramétrage de l'algorithme de traitement, par exemple conjointement aux matrices D0 et D1, de façon à :

- minimiser l'erreur de projection err0 des signaux y de type choc sur la matrice D0 et maximiser l'erreur de projection err0 des signaux y de type arc sur la matrice D0 ; et
- minimiser l'erreur de projection err1 des signaux de type arc sur la matrice D1 et maximiser l'erreur de projection err1 des signaux de type choc sur la matrice D1.

Les étapes 203 et 205 peuvent être mises en oeuvre en parallèle ou séquentiellement.

Le procédé de la figure 2 comprend en outre, après les étapes 203 et 205, une étape 207 de détection de la présence ou non d'un arc électrique par comparaison des valeurs d'erreur de projection err0 et err1 déterminées aux étapes 203 et 205.

Plus particulièrement, dans cet exemple, le dispositif de traitement 106 compare le rapport err1/err0 à un seuil TH prédéterminé.

Si le rapport err1/err0 est supérieur ou égal au seuil TH (Y), le dispositif de traitement 106 en déduit que le signal acoustique d'entrée y n'est pas la signature d'un arc électrique. Le procédé reprend alors à partir de l'étape 201, avec l'acquisition d'un nouveau signal acoustique d'entrée y.

Si en revanche le rapport err1/err0 est inférieur au seuil TH (N), le dispositif de traitement 106 en déduit que le signal acoustique d'entrée y est caractéristique d'un arc électrique. Une étape 209 de protection du système électrique 100 est alors mise en oeuvre par le dispositif de traitement 106, consistant par exemple à déclencher une alarme et/ou à interrompre un courant électrique d'alimentation du système électrique 100.

Le seuil TH est par exemple égal à 1. Dans ce cas, le test réalisé à l'étape 207 consiste à déterminer si l'erreur de projection du signal y sur le dictionnaire des arcs D1 est :

- supérieure ou égale à l'erreur de projection du signal y sur le dictionnaire des chocs D0, auquel cas le dispositif de traitement 106 en déduit que le signal acoustique d'entrée y n'est pas la signature d'un arc électrique ; ou
- inférieure à l'erreur de projection du signal y sur le dictionnaire des chocs D0, auquel cas le dispositif de traitement 106 en déduit que le signal acoustique d'entrée y est la signature d'un arc électrique.

A titre de variante, le seuil TH peut être différent de 1, selon les performances de détection que l'on cherche à obtenir. Plus généralement, le seuil TH peut être fixé en fonction des spécifications visées en termes de probabilité de fausse détection ou fausse alarme (Pfa) et de probabilité de non détection (Pnd).

Les matrices dictionnaires D0 et D1 ainsi que les valeurs T0 et T1 peuvent être déterminées par apprentissage lors d'une phase initiale de paramétrage de l'algorithme de détection, par exemple à partir de signaux acoustiques d'arcs et de chocs réellement mesurés dans le système électrique lors d'une phase de caractérisation du système, où à partir d'une base de données de signaux acoustiques d'arcs et de chocs mesurés dans d'autres systèmes électriques.

A titre d'exemple, on considère deux sous-ensembles de signaux acoustiques notés Y0 et Y1. L'ensemble Y0, appelé matrice des chocs, est constitué d'un ensemble de vecteurs colonnes de dimension n correspondant à des signaux acoustiques réellement mesurés caractéristiques de chocs dans un système électrique. L'ensemble Y1, appelé matrice des arcs, est constitué d'un ensemble de vecteurs colonnes de dimensions n correspondant à des signaux acoustiques réellement mesurés caractéristiques d'arcs électriques dans un système électrique.

A titre d'exemple, la matrice dictionnaire D0 et la matrice dictionnaire D1 sont déterminées à partir respectivement de la matrice des chocs Y0 et de la matrice des arcs Y1 par une méthode d'analyse en composantes principales ("principal component analysis" en anglais). Par construction, tous les vecteurs colonnes de chaque matrice dictionnaire sont alors orthogonaux deux à deux.

A titre de variante, la matrice dictionnaire D0 et la matrice dictionnaire D1 sont déterminées à partir respectivement de la matrice des chocs Y0 et de la matrice des arcs Y1 par une méthode de décomposition sur un dictionnaire non orthogonal, par une méthode de type K-SVD, par exemple telle que décrite dans l'article intitulé " K-Svd: An algorithm for designing overcomplete dictionaries for sparse representation" de M. Aharon et al. (IEEE Transactions on signal processing, 54(11):4311-4322, 2006).

Un avantage de la méthode K-SVD par rapport à la méthode d'analyse en composantes principales est qu'elle permet de relâcher la contrainte d'orthogonalité et ainsi d'obtenir des dictionnaires mieux adaptés à la représentation des signaux acoustiques d'arcs et de chocs, et donc de minimiser l'erreur commise en approximant le signal acoustique y par sa projection sur le dictionnaire D0 ou D1.

De préférence, la matrice dictionnaire D0 et la matrice dictionnaire D1 sont déterminées à partir de la matrice des chocs Y0 et de la matrice des arcs Y1 par une méthode de décomposition sur un dictionnaire non orthogonal, en imposant une contrainte de faible cohérence entre les dictionnaires D0 et D1, par une méthode de type DLSI, par exemple telle que décrite dans l'article intitulé "Classification and clustering via dictionary learning with structured incoherence and shared features" de I. Ramirez et al. (In Computer Vision and Pattern Recognition, CVPR, 2010 IEEE Conference on, pages 3501-3508).

En effet, une limitation de la méthode K-SVD mentionnée ci-dessus est que les matrices dictionnaires D0 et D1 sont calculées séparément pour chaque classe de signaux. Il existe donc un risque d'obtenir une cohérence relativement forte entre les vecteurs des deux dictionnaires (c'est-à-dire qu'un signal acoustique peut être aussi fortement corrélé à la matrice D0 qu'à la matrice D1). Dans ce cas, la représentation d'un signal acoustique y d'arc ou de choc pourrait être aussi bonne sur le dictionnaire des chocs D0 que sur le dictionnaire des arcs D1, empêchant une bonne discrimination des arcs par rapport aux chocs (même si le signal est bien représenté sur chacun des dictionnaires). La méthode DLSI introduit un paramètre permettant de contrôler la cohérence entre les dictionnaires et de forcer une cohérence relativement faible entre les deux dictionnaires. Autrement dit, la méthode DLSI permet de déterminer deux dictionnaires suffisamment dé-corrélés l'un par rapport à l'autre, tout en veillant à maintenir une bonne capacité de représentation des signaux acoustiques. En effet, il est en pratique aussi important de pouvoir bien représenter les signaux sur les dictionnaires, que d'obtenir une bonne discrimination entre les arcs et les chocs. La méthode DLSI permet d'obtenir un bon compromis entre ces deux objectifs.

La méthode DLSI consiste par exemple à résoudre le problème de minimisation suivant :

[Math 5]

$$\underset{\{Dr,xr\},r=0,1}{\mathrm{argmin}} \sum_{r=0}^{1} \|Yr\text{-}Dr^{*}xr\|_{F}^{2} + P^{*}\|D0^{T}{*}D1\|_{F}^{2}$$

où le terme :

[Math 6]

$$\|D0^{T}{*}D1\|_{F}$$

désigne la valeur normalisée selon la norme de Frobenius du produit matriciel de la transposée de D0 par D1, et où P est un coefficient de pondération permettant de contrôler la cohérence entre les matrices D0 et D1. Autrement dit, la méthode DLSI conduit à minimiser conjointement l'erreur de représentation des signaux de la matrice des chocs Y0 sur le dictionnaire D0, l'erreur de représentation des signaux de la matrice des arcs Y1 sur le dictionnaire D1, et la corrélation entre les dictionnaires D0 et D1. Plus le coefficient P sera choisi élevé, moins les matrices dictionnaires D0 et D1 seront cohérentes, au prix, éventuellement, d'une capacité de représentation réduite des signaux.

On notera qu'à titre de variante, plutôt que d'effectuer l'apprentissage des matrices dictionnaires D0 et D1 sur des signaux pleins (i.e. de dimension n), on pourra réaliser l'apprentissage à partir de signaux de dimension réduite, obtenus par combinaison des composantes des signaux pleins (i.e. les vecteurs colonnes des matrices Y0 et Y1), pondérées par des coefficients aléatoires ou pseudo-aléatoires, tel que décrit par exemple dans l'article intitulé "Compressive k-svd" de Farhad Pourkamali Anaraki et al. (Acoustics, Speech and Signal Processing, ICASSP, 2013 IEEE, pages 5469-5473).

Dans ce cas, la détection proprement dite pourra être réalisée à partir de signaux acoustiques d'entrée y de dimension réduite, également obtenus par combinaison des composantes du signal plein, pondérées par des coefficients aléatoires ou pseudo-aléatoires. Ceci permet avantageusement de réduire la quantité de données à transmettre au dispositif de traitement 106 et/ou à traiter par le dispositif de traitement 106 pendant la phase de détection proprement dite.

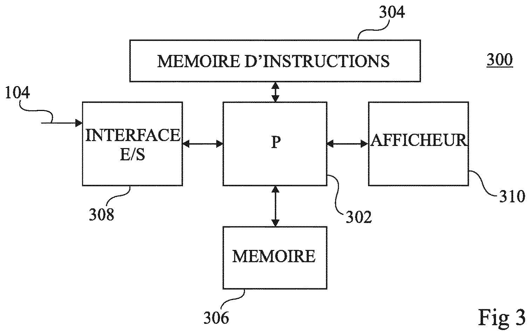

La figure 3 illustre un exemple de réalisation du dispositif de traitement 106 de la figure 1. Le dispositif 106 peut comprendre un ou plusieurs processeurs 302 (P) recevant des instructions mémorisées dans une mémoire d'instructions 304. Le dispositif de traitement 300 peut en outre comporter une mémoire 306 configurée pour mémoriser les différentes grandeurs calculées lors de la mise en oeuvre du procédé de détection d'arc électrique, par exemple les erreurs de projection err0 et err1 du signal d'entrée y sur les matrices dictionnaires D0 et D1. La mémoire 306 peut en outre mémoriser le signal variable dans le temps 104 provenant du capteur 102, qui est par exemple reçu par le processeur 302 par l'intermédiaire d'une interface d'entrée/sortie 308. De plus, la mémoire 306 peut mémoriser les coefficients des matrices dictionnaires D0 et D1 utilisées par le procédé de détection. L'interface d'entrée/sortie 308 peut en outre fournir le signal de sortie 112 du dispositif 106 adapté à contrôler le fonctionnement du système électrique 100 dans le cas où un arc électrique est détecté. Le dispositif de traitement 300 comprend par exemple en plus un afficheur 310, qui par exemple fournit une interface utilisateur et des moyens pour alerter un utilisateur si un arc électrique est détecté.

## Revendications

**1.** Procédé de détection d'un arc électrique dans un système électrique (100), comprenant les étapes suivantes :

a) acquérir un premier signal (104 ; y) provenant d'au moins un capteur (102) détectant des ondes acoustiques dans le système (100) ;

b) calculer, au moyen d'un dispositif électronique de traitement (106), une première valeur (err0) représentative de l'erreur entre le premier signal et une première projection (x0) du premier signal dans un premier espace de représentation défini par une première matrice dictionnaire (D0) ;

c) calculer, au moyen du dispositif électronique de traitement (106), une deuxième valeur (err1) représentative de l'erreur entre le premier signal et une deuxième projection (x1) du premier signal dans un deuxième espace de représentation défini par une deuxième matrice dictionnaire (D1) ; et

d) comparer les première (err0) et deuxième (err1) valeurs au moyen du dispositif électronique de traitement (106) et en déduire si un arc électrique s'est produit dans le système,

dans lequel les première (D0) et deuxième (D1) matrices dictionnaires sont déterminées, lors d'une phase préalable de caractérisation, par apprentissage à partir d'un premier ensemble (Y0) de signaux acoustiques caractéristiques de chocs dans le système électrique (100) et d'un deuxième ensemble (Y1) de signaux acoustiques caractéristiques d'arcs électriques dans le système électrique (100), de façon à :

- minimiser une erreur de projection des signaux de choc sur la première matrice (D0) et maximiser une erreur de projection des signaux d'arc sur la première matrice (D0) ; et
- minimiser une erreur de projection des signaux d'arc sur la deuxième matrice (D1) et maximiser une erreur de projection des signaux de choc sur la deuxième matrice (D1), dans lequel, à l'étape d), le dispositif de traitement (106) détermine si le rapport de la deuxième valeur (err1) sur la première valeur (err0) est supérieur ou non à un seuil (TH) prédéterminé, et en déduit si un arc électrique s'est produit ou non dans le système.

2. Procédé selon la revendication 1, dans lequel le seuil (TH) est égal à 1.

3. Procédé selon la revendication 1 ou 2, dans lequel, à l'étape b), la première valeur (err0) est déterminée par un algorithme itératif de poursuite adaptative comprenant les étapes successives suivantes :

e1) définir un vecteur résidu ERRO et lui affecter la valeur du premier signal (y) ;
e2) rechercher dans la première matrice dictionnaire (D0) le vecteur colonne D0<j> le plus corrélé avec le vecteur résidu ERRO ;
e3) soustraire au vecteur résidu ERRO la contribution au vecteur résidu ERRO du vecteur colonne D0<j> déterminé à l'étape précédente ;
e4) répéter les étapes e2) et e3) un nombre T0 prédéterminé de fois ; et
e5) affecter à la première valeur (err0) une valeur représentative de la norme du vecteur résidu ERRO.

4. Procédé selon l'une quelconque des revendications 1 à 3, dans lequel, à l'étape c), la deuxième valeur (err1) est déterminée par un algorithme itératif de poursuite adaptative comprenant les étapes successives suivantes :

e1') définir un vecteur résidu ERR1 et lui affecter la valeur du premier signal (y) ;
e2') rechercher dans la deuxième matrice dictionnaire (D1) le vecteur colonne D1<j> le plus corrélé avec le vecteur résidu ERR1 ;
e3') soustraire au vecteur résidu ERR1 la contribution au vecteur résidu ERR1 du vecteur colonne D1<j> déterminé à l'étape précédente ;
e4') répéter les étapes e2') et e3') un nombre T1 prédéterminé de fois ; et
e5') affecter à la deuxième valeur (err1) une valeur représentative de la norme du vecteur résidu ERR1.

5. Procédé selon l'une quelconque des revendications 1 à 4, comprenant en outre une étape de mise en sécurité du système électrique (100) lorsqu'il est déterminé à l'étape d) qu'un arc électrique est survenu dans le système électrique (100).

6. Procédé selon la revendication 5, dans lequel l'étape de mise en sécurité comprend le déclenchement d'une alarme.

7. Procédé selon la revendication 5 ou 6, dans lequel l'étape de mise en sécurité comprend l'interruption d'un courant électrique d'alimentation du système électrique (100).

8. Dispositif de détection d'un arc électrique dans un système électrique (100), comprenant un capteur (102) configuré pour détecter des ondes acoustiques dans le système (100), et un dispositif électronique de traitement (106), **caractérisé en ce que** le dispositif de traitement est adapté à mettre en oeuvre un procédé selon l'une quelconque des revendications 1 à 7.

**Patentansprüche**

1. Verfahren zum Detektieren eines elektrischen Lichtbogens in einem elektrischen System (100), aufweisend die folgenden Schritte:

a) Erfassen eines ersten Signals (104; y), das von wenigstens einem Sensor (102) kommt, der akustische Wellen in dem System (100) detektiert;

b) Berechnen, unter Verwendung einer elektronischen Verarbeitungsvorrichtung (106), eines ersten Wertes (err0), der für den Fehler zwischen dem ersten Signal und einer ersten Projektion (x0) des ersten Signals in einem ersten Darstellungsraum, der durch eine erste Wörterbuchmatrix (D0) definiert ist, repräsentativ ist;

c) Berechnen, unter Verwendung der elektronischen Verarbeitungsvorrichtung (106), eines zweiten Wertes (err1), der für den Fehler zwischen dem ersten Signal und einer zweiten Projektion (x1) des ersten Signals in einem zweiten Darstellungsraum, der durch eine zweite Wörterbuchmatrix (D1) definiert ist, repräsentativ ist; und

d) Vergleichen der ersten (err0) und zweiten (err1) Werte unter Verwendung der elektronischen Verarbeitungsvorrichtung (106) und Ableiten, ob in dem System ein elektrischer Lichtbogen erzeugt wurde, wobei die erste (D0) und die zweite (D1) Wörterbuchmatrix während einer vorhergehenden Charakterisierungsphase bestimmt werden durch Lernen von einem ersten Satz (Y0) von charakteristischen akustischen Signalen von Schocks in dem elektrischen System (100) und einem zweiten Satz (Y1) von charakteristischen akustischen Signalen von elektrischen Lichtbögen in dem elektrischen System (100), zum

- Minimieren eines Projektionsfehlers der Schocksignale auf die erste Matrix (D0) und Maximieren eines Projektionsfehlers der Lichtbogensignale auf die erste Matrix (D0); und
- Minimieren eines Projektionsfehlers der Lichtbogensignale auf die zweite Matrix (D1) und Maximieren eines Projektionsfehlers der Schocksignale auf die zweite Matrix (D1), wobei im Schritt d) die Verarbeitungsvorrichtung (106) bestimmt, ob das Verhältnis des zweiten Wertes (err1) zum ersten Wert (err0) über einem vorbestimmten Schwellenwert (TH) liegt oder nicht, und daraus ableitet, ob in dem System ein elektrischer Lichtbogen erzeugt wurde oder nicht.

2. Verfahren nach Anspruch 1, wobei der Schwellenwert (TH) gleich 1 ist.

3. Verfahren nach Anspruch 1 oder 2, wobei im Schritt b) der erste Wert (err0) durch einen adaptiven iterativen Verfolgungsalgorithmus bestimmt wird, der die folgenden aufeinanderfolgenden Schritte aufweist:

e1) Definieren eines Restvektors ERR0 und Zuordnen des Wertes des ersten Signals (y) zu diesem;
e2) Suchen in der ersten Wörterbuchmatrix (D0) nach dem Spaltenvektor D0<j>, der am stärksten mit dem Restvektor ERR0 korreliert ist;
e3) Subtrahieren, vom Restvektor ERR0, des Beitrags zu dem Restvektor ERR0 des Spaltenvektors D0<j>, der im vorhergehenden Schritt bestimmt wurde;
e4) Wiederholen der Schritte e2) und e3) eine vorbestimmte Anzahl T0 von Malen; und
e5) Zuordnen zu dem ersten Wert (err0) eines Werts, der repräsentativ für die Norm des Restvektors ERR0 ist.

4. Verfahren nach einem der Ansprüche 1 bis 3, wobei im Schritt c) der zweite Wert (err1) durch einen adaptiven iterativen Verfolgungsalgorithmus bestimmt wird, der die folgenden aufeinanderfolgenden Schritte aufweist:

e1') Definieren eines Restvektors ERR1 und Zuordnen des Wertes des ersten Signals (y) zu diesem;
e2') Suchen in der zweiten Wörterbuchmatrix (D1) nach dem Spaltenvektor D1<j>, der am stärksten mit dem Restvektor ERR1 korreliert ist;
e3') Subtrahieren, vom Restvektor ERR1, des Beitrags zum Restvektor ERR1 des Spaltenvektors D1<j>, der im vorhergehenden Schritt bestimmt wurde;
e4') Wiederholen der Schritte e2') und e3') eine vorbestimmte Anzahl T1 von Malen; und
e5') Zuordnen dem zweiten Wert (err1) eines Werts, der repräsentativ für die Norm des Restvektors ERR1 ist.

5. Verfahren nach einem der Ansprüche 1 bis 4, weiterhin aufweisend einen Schritt des Sicherns des elektrischen Systems (100), wenn in Schritt d) festgestellt wird, dass in dem elektrischen System (100) ein elektrischer Lichtbogen aufgetreten ist.

6. Verfahren nach Anspruch 5, wobei der Schritt des Sicherns das Auslösen eines Alarms aufweist.

7. Verfahren nach Anspruch 5 oder 6, wobei der Sicherungsschritt das Unterbrechen eines elektrischen Versorgungsstroms des elektrischen Systems (100) aufweist.

8. Vorrichtung zum Erfassen eines elektrischen Lichtbogens in einem elektrischen System (100), aufweisend einen Sensor (102), der konfiguriert ist zum Detektieren von akustischen Wellen in dem System (100), und eine elektronische Verarbeitungsvorrichtung (106), **dadurch gekennzeichnet, dass** die Verarbeitungsvorrichtung konfiguriert ist zum Implementieren eines Verfahrens nach einem der Ansprüche 1 bis 7.

**Claims**

1. A method for detecting an electric arc in an electrical system (100), comprising the following steps:

   a) acquiring a first signal (104; y) coming from at least one sensor (102) detecting acoustic waves in the system (100) ;
   b) calculating, using an electronic processing device (106), a first value (err0) representative of the error between the first signal and a first projection (x0) of the first signal in a first representation space defined by a first dictionary matrix (D0);
   c) calculating, using the electronic processing device (106), a second value (err1) representative of the error between the first signal and a second projection (x1) of the first signal in a second representation space defined by a second dictionary matrix (D1); and
   d) comparing the first (err0) and second (err1) values using the electronic processing device (106) and deducing whether an electric arc has been produced in the system, wherein the first (D0) and second (D1) dictionary matrices are determined, during a prior characterization phase, by learning from a first set (Y0) of characteristic acoustic signals of shocks in the electrical system (100) and a second set (Y1) of characteristic acoustic signals of electric arcs in the electrical system (100), in order to:

      - minimize a projection error of the shock signals on the first matrix (D0) and maximize a projection error of the arc signals on the first matrix (D0); and
      - minimize a projection error of the arc signals on the second matrix (D1) and maximize a projection error of the shock signals on the second matrix (D1), wherein, in step d), the processing device (106) determines whether or not the ratio of the second value (err1) to the first value (err0) is above a predetermined threshold (TH), and deduces therefrom whether or not an electric arc has been produced in the system.

2. The method according to claim 1, wherein the threshold (TH) is equal to 1.

3. The method according to claim 1 or 2, wherein, in step b), the first value (err0) is determined by an adaptive pursuit iterative algorithm comprising the following successive steps:

   e1) defining a residue vector ERR0 and assigning to it the value of the first signal (y);
   e2) searching in the first dictionary matrix (D0) for the column vector D0<j> that is most correlated with the residue vector ERR0;
   e3) subtracting, from the residue vector ERR0, the contribution to the residue vector ERR0 of the column vector D0<j> determined in the preceding step;
   e4) repeating the steps e2) and e3) a predetermined number T0 of times; and
   e5) assigning to the first value (err0) a value representative of the norm of the residue vector ERR0.

4. The method according to any one of claims 1 to 3, wherein, in step c), the second value (err1) is determined by an adaptive pursuit iterative algorithm comprising the following successive steps:

   e1') defining a residue vector ERR1 and assigning to it the value of the first signal (y);
   e2') searching in the second dictionary matrix (D1) for the column vector D1<j> that is most correlated with the residue vector ERR1;
   e3') subtracting, from the residue vector ERR1, the contribution to the residue vector ERR1 of the column vector D1<j> determined in the preceding step;
   e4') repeating the steps e2') and e3') a predetermined number T1 of times; and
   e5') assigning to the second value (err1) a value representative of the norm of the residue vector ERR1.

5. The method according to any one of claims 1 to 4, further comprising a step of securing the electrical system (100) when it is determined in step d) that an electric arc has occurred in the electrical system (100).

6. The method according to claim 5, wherein the securing step comprises triggering an alarm.

7. The method according to claim 5 or 6, wherein the securing step comprises interrupting an electrical supply current of the electrical system (100).

8. A device for detecting an electric arc in the electrical system (100), comprising a sensor (102) configured to detect acoustic waves in the system (100), and an electronic processing device (106), **characterized in that** the processing device is configured to implement a method according to any one of claims 1 to 7.

Fig 1

$$err0 = \| y - D0 * x0 \|_2^2$$

$$err1 = \| y - D1 * x1 \|_2^2$$

$$\frac{err1}{err0} \geq TH ?$$

ACTION

Fig 2

EP 3 647 798 B1

Fig 3

14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Q. XIE ; Y. WANG ; T. LI ; X. BIAN ; H. ZHANG ; Y. XU.** Application of signal sparse decomposition in the detection of partial discharge by ultrasonic array method. *IEEE Transactions on Dielectrics and Electrical Insulation,* Août 2015, vol. 22 (4), 2031-2040
- **X. JIANG ; W. ZENG ; E. CHENG.** A Fast Algorithm for Sparse Channel Estimation via Orthogonal Matching Pursuit. *IEEE 73rd Vehicular Technology Conference (VTC Spring),* 2011, 1-5
- **G. DAVIS et al.** Adaptive time-frequency decompositions with matching pursuits. *Optical Engineering.,* 1994, vol. 33, 2183

- **Y. PATI et al.** Orthogonal Matching Pursuit: recursive function approximation with application to wavelet Decomposition. *Asilomar Conf. on Signais, Systems and Comput.,* 1993
- **M. AHARON et al.** K-Svd: An algorithm for designing overcomplete dictionaries for sparse representation. *IEEE Transactions on signal processing,* 2006, vol. 54 (11), 4311-4322
- **I. RAMIREZ et al.** Classification and clustering via dictionary learning with structured incoherence and shared features. *Computer Vision and Pattern Recognition, CVPR, 2010 IEEE Conference on,* 3501-3508
- Compressive k-svd. **FARHAD POURKAMALI ANARAKI et al.** Acoustics, Speech and Signal Processing, ICASSP. IEEE, 2013, 5469-5473